# EUROPÄISCHE PATENTANMELDUNG

(11) **EP 4 668 295 A1**
(43) Veröffentlichungstag der Anmeldung: **24.12.2025**
(21) Anmeldenummer: 24182836.7
(22) Anmeldetag: 18.06.2024
(51) Int. Cl.: H01F 6/04, G01R 33/38, G01R 33/3815

(54) **KÜHLVORRICHTUNG ZUM KÜHLEN EINES SUPRALEITENDEN MAGNETEN**

(71) Anmelder: Siemens Healthineers AG, 91301 Forchheim (DE)
(72) Erfinder: Model, Volker, 90766 Fürth (DE)
(74) Vertreter: Siemens Healthineers Patent Attorneys

(57) **Zusammenfassung**

Die Erfindung betrifft eine Kühlvorrichtung zum Kühlen eines supraleitenden Magneten (2), insbesondere eines supraleitenden Magneten (2) für ein Magnetresonanztomographiesystem, wobei die Kühlvorrichtung umfasst: ein erstes Kühlsystem (10), wobei das erste Kühlsystem (10) dazu ausgestaltet ist, eine Kühlung für den supraleitenden Magneten (2) während eines Betriebs des supraleitenden Magneten (2) aufrechtzuerhalten und ein zweites Kühlsystem (20), wobei das zweite Kühlsystem (20) dazu ausgestaltet ist, bei einem Ausfall des ersten Kühlsystems (10) die Kühlung für den supraleitenden Magneten (2) aufrechtzuerhalten und dazu mit in dem supraleitenden Magneten (2) gespeicherter Energie betrieben zu werden.

## Beschreibung

*Unabhängig vom grammatikalischen Geschlecht eines bestimmten Begriffes sind Personen mit männlicher, weiblicher oder anderer Geschlechteridentität mit umfasst.*

Die Erfindung betrifft eine Kühlvorrichtung zum Kühlen eines supraleitenden Magneten, ein Magnetsystem umfassend einen supraleitenden Magneten, ein Magnetresonanztomographiesystem, ein Verfahren zum Aufrechterhalten einer Kühlung eines supraleitenden Magneten und eine Verwendung eines zweiten Kühlsystems für ein Magnetsystem mit einem supraleitenden Magneten.

Die Leitungen von supraleitenden Magneten, die beispielsweise für Magnetresonanzsysteme verwendet werden, müssen aufgrund ihrer typischerweise niedrigen Sprungtemperatur gekühlt werden. Kühlsysteme für supraleitende Magneten sind im Stand der Technik grundsätzlich bekannt. Klassischerweise werden supraleitenden Magnete zur Kühlung in einem Kryostaten angeordnet, insbesondere in einem Bad aus flüssigem Kühlmittel. Um ausreichend niedrige Temperaturen zu erreichen wird als Kühlmittel in der Regel flüssiges Helium verwendet. Es gibt Ansätze, die Menge an Helium zu reduzieren. Dazu ist der supraleitende Magnet in einem Vakuum angeordnet und wird durch Wärmeleitung über eine thermische Verbindung zu einem Tieftemperaturkühlgerät gekühlt. Auch hierzu wird in der Regel ebenfalls das flüssige Kühlmittel, insbesondere flüssiges Helium, eingesetzt, welches über die Wärmeleitung mit den Supraleitungen verbunden ist. Die Menge an Helium ist jedoch in diesem Fall deutlich geringer. Derartig gekühlte supraleitende Magneten, die nicht in einem Bad aus flüssigem Kühlmittel angeordnet sind, werden auch als trockene supraleitende Magnete bezeichnet. Beispielsweise ist es üblich, mehrere tausend Liter Helium für das Heliumbad zu verwenden, während für trockene Magneten Helium mit einem Volumen von beispielsweise weniger als einem Liter vorstellbar ist.

Vorteilhaft kann sein, dass bei trockenen supraleitenden Magneten aufgrund der geringen Menge von Helium ein Helium-Abdampf vermieden werden kann, der bei klassischer Kühlung im Heliumbad typischerweise von einem übergeordneten Heliumsystem zur Rückführung des Helium-Abdampfes aufgefangen wird. Trockene supraleitende Magnete können insbesondere unabhängig ohne ein übergeordnetes Heliumsystem funktionieren.

Nachteilig an trockenen supraleitenden Magneten ist jedoch, dass aufgrund der geringen Menge des Heliums auch die Wärmekapazität des Heliums gering ist. Fällt das Kühlsystem aus, das dafür verantwortlich ist, das Helium zu verflüssigen, so verdampft das Helium recht bald und als Folge davon kann der Supraleiter nicht mehr ausreichend gekühlt werden, wodurch sich auch der Supraleiter aufwärmt. Dies kann bereits nach einigen Minuten, beispielsweise in der Größenordnung von 20 Minuten, eintreten. Solche trocknen supraleitenden Magnete müssen bei Ausfall der Kühlung daher schnell in einen sicheren Zustand gebracht werden, insbesondere muss die Stromstärke im Supraleiter so weit reduziert werden, dass ein unkontrollierter Magnet-Quench verhindert wird.

Bei Magneten hoher Feldstärke ist die Induktivität derart hoch, dass bei maximal zulässiger Magnetspannung die Zeit für die Reduzierung des Magnetstroms sehr groß ist. Die Folge eines Ausfalls der Kühlung ist somit ein Abbau des magnetischen Feldes sowie eine deutliche Temperaturerhöhung. Beides führt in der Regel dazu, dass das System, welches den supraleitenden Magneten verwendet, beispielsweise ein Magnetresonanztomographiesystem, für einen längeren Zeitraum nicht wieder einsatzfähig gemacht werden kann. Es kann somit zu erheblichen Ausfallzeiten kommen, während der Magnet durch Herunterkühlen wieder betriebsbereit gemacht wird. Auch das Aufbauen des Magnetfelds kann bei großen Feldstärken mehrere Stunden dauern.

Nach Kenntnis der Anmelderin ist dieser Nachteil unter anderem ein Grund, warum ein solches System mit einem trockenen Magneten bislang nicht kommerziell für Magnete mit besonders hohen Feldstärken realisiert wurde.

Es ist daher eine Aufgabe der vorliegenden Erfindung, eine Lösung für die oben beschriebenen Probleme zu finden, insbesondere einer Erwärmung des supraleitenden Magneten, insbesondere trockenen supraleitenden Magneten, bei einem Ausfall der Kühlung zumindest vorübergehend entgegenwirken zu können.

Diese Aufgabe wird gelöst durch eine Kühlvorrichtung gemäß Anspruch 1, ein Magnetsystem gemäß Anspruch 6, ein Magnetresonanztomographiesystem gemäß Anspruch 12, ein Verfahren gemäß Anspruch 13, und eine Verwendung gemäß Anspruch 15. Weitere Merkmale und Vorteile ergeben sich aus den abhängigen Ansprüchen, der Beschreibung und den beigefügten Figuren.

Gemäß einem ersten Aspekt der Erfindung ist eine Kühlvorrichtung zum Kühlen eines supraleitenden Magneten, insbesondere eines supraleitenden Magneten für ein Magnetresonanztomographiesystem (MRT-System), vorgesehen. Die Kühlvorrichtung umfasst ein erstes Kühlsystem, wobei das erste Kühlsystem einen ersten Kühler umfasst und dazu ausgestaltet ist, eine Kühlung für den supraleitenden Magneten während eines Betriebs des supraleitenden Magneten aufrechtzuerhalten und ein zweites Kühlsystem, wobei das zweite Kühlsystem einen zweiten Kühler umfasst und dazu ausgestaltet ist, bei einem Ausfall des ersten Kühlsystems die Kühlung für den supraleitenden Magneten aufrechtzuerhalten und dazu mit in dem supraleitenden Magneten gespeicherter Energie betrieben zu werden. Vorteilhafterweise kann mit der erfindungsgemäßen Kühlvorrichtung eine Kühlung des Magneten auch dann aufrechterhalten werden, wenn das erste Kühlsystem ausfällt, insbesondere sowohl bei einem Stromausfall bzw. einem Ausfall der Energieversorgung als auch bei Ausfall einer Komponente des ersten Kühlsystems. Somit kann eine Kühlung des Magneten zumindest vorrübergehend unabhängig von einer Stromversorgung und auch von einzelnen Systemkomponenten des ersten Kühlsystems erfolgen. Insbesondere kann bei einem Ausfall des Magnetsystems oder eines Teils des Magnetsystems immer noch das zweite Kühlsystem funktionieren. Dadurch kann der Magnet länger auf seiner Betriebstemperatur gehalten werden. Ausfälle der Energieversorgung und/oder von Systemkomponenten können somit überbrückt werden. Dar Magnet kann insbesondere direkt nachdem das System, insbesondere das erste Kühlsystem, wieder betriebsbereit ist auf seine Systemfeldstärke gebracht werden ohne weitere Wartezeiten, solang die Ausfallzeit geringer als die Betriebszeit des zweiten Kühlsystems ist, die durch die in dem supraleitenden Magneten gespeicherte Energie bestimmt ist. Weiterhin kann durch Verwenden der Energie des Magneten für das zweite Kühlsystem ein Abbau dieser Energie erfolgen, wobei nur ein geringerer Teil dieser Energie in Wärme umgewandelt wird bzw. werden muss. Somit kann einer Erwärmung weiter entgegengewirkt werden.

Im Rahmen dieser Erfindung kann unter einem supraleitenden Magneten insbesondere ein Magnet verstanden werden, der den Effekt der Supraleitung ausnutzt, um große Magnetfelder zu erzeugen. In der Regel umfasst ein supraleitender Magnet eine Magnetspule mit Spulenwicklungen zum Erzeugen des Magnetfelds. Der supraleitende Magnet kann insbesondere ein supraleitender Magnet eines Magnetresonanztomographiesystems sein. Vorteilhafterweise kann der supraleitende Magnet optional ein Magnet mit hoher Feldstärke sein. Beispielsweise kann der supraleitende Magnet dazu ausgestaltet sein, eine Feldstärke von zumindest 2 Tesla, vorzugweise zumindest 3 Tesla aufzubauen. Durch die verlängerte Kühlzeit auch bei einem Ausfall, sind diese hohen Feldstärken insbesondere auch für trockene Magneten ausreichend sicher denkbar. Die Kühlvorrichtung ist insbesondere dazu geeignet, den supraleitenden Magneten auf eine Temperatur unterhalb seiner Sprungtemperatur zu kühlen bzw. auf dieser Temperatur zu halten. Insbesondere kann die Kühlvorrichtung einen Kühlmittelbehälter für Kühlmittel umfassen. Das Kühlmittel ist in der Regel flüssiges Helium, um ausreichend geringe Temperaturen unterhalb der Sprungtemperatur erreichen zu können. Grundsätzlich sind jedoch auch andere Kühlmittel denkbar. Beispielsweise könnte, wenn das supraleitende Material eine höhere Sprungtemperatur aufweist, auch flüssiger Stückstoff als Kühlmittel denkbar sein. Die Kühlvorrichtung ist insbesondere dazu ausgestaltet, das Kühlmittel zu verflüssigen. Die Kühlvorrichtung kann zumindest einen Kaltkopf zum Kühlen und/oder Verflüssigen des Kühlmittels umfassen. Der Kühlmittelbehälter für das flüssige Kühlmittel, insbesondere flüssiges Helium, kann optional dazu ausgestaltet sein, ein Volumen an flüssigem Kühlmittel von weniger als 2 Liter, vorzugsweise weniger als 1 Liter, zu beinhalten. Mit anderen Worten kann die Kühlvorrichtung dazu ausgestaltet sein, den supraleitenden Magneten unter Verwendung von weniger als 2 Liter, vorzugsweise weniger als 1 Liter, an flüssigem Kühlmittel zu kühlen. Vorteilhafterweise kann es mit der erfindungsgemäßen Kühlvorrichtung möglich sein, einen trockenen supraleitenden Magneten mit wenig verflüssigtem Kühlmitte relativ sicher zu kühlen, indem bei einem Systemausfall, umfassend einen Ausfall des ersten Kühlsystems, durch das zweite Kühlsystem eine Kühlung länger aufrechterhalten werden kann. Insbesondere kann der Magnet bei einem Ausfall wegen der noch länger vorhandenen Kühlung (durch das zweite Kühlsystem) langsamer heruntergefahren werden.

Die Kühlvorrichtung umfasst ein erstes Kühlsystem und ein zweites Kühlsystem. Das erste Kühlsystem kann auch als primäres Kühlsystem oder Hauptkühlsystem und das zweite Kühlsystem als sekundäres Kühlsystem oder Notkühlsystem bezeichnet werden. Statt dem Begriff Kühlsystem kann im Rahmen dieser Erfindung auch speziell der Begriff Kühlkreislauf vorgesehen sein. Entsprechend kann die Kühlvorrichtung einen ersten Kühlkreislauf und einen zweiten Kühlkreislauf umfassen. Der Begriff Kühlsystem ist im Rahmen dieser Erfindung breit zu verstehen und er bezeichnet generell ein (Teil-)Kühlsystem zum Kühlen eines supraleitenden Magneten. Vorzugsweise kann das zweite Kühlsystem unabhängig von dem ersten Kühlsystem ausgestaltet sein.

Das erste Kühlsystem ist dazu ausgestaltet, eine Kühlung für den supraleitenden Magneten während eines Betriebs des supraleitenden Magneten aufrechtzuerhalten. Das erste Kühlsystem kann vorzugsweise dazu ausgestaltet sein, ein Herunterkühlen des supraleitenden Magneten auf eine Temperatur unter seine Sprungtemperatur und ein Aufrechterhalten dieser Temperatur zu ermöglichen. Das erste Kühlsystem kann einem im Stand der Technik üblichen Kühlkreislauf bzw. einem übliches Kühlsystem zum Kühlen eines supraleitenden Magneten entsprechen bzw. entsprechende Komponenten aufweisen. Das erste Kühlsystem kann als zweistufiges Kühlsystem ausgestaltet sein. Die zweite Stufe ist insbesondere dazu ausgestaltet, eine Temperatur bereitzustellen, die unterhalb der Sprungtemperatur des supraleitenden Magneten liegt. Die erste Stufe ist insbesondere dazu ausgestaltet eine Vorkühlung auf eine etwas höhere Temperatur als die zweite Stufe bereitzustellen. Bei einer zweistufigen Kühlung kann beispielsweise eine erste Stufe auf eine Temperatur im Bereich von 50-80 K und/oder der Temperatur von flüssigem Stickstoff, und eine zweite Stufe auf eine Temperatur im Bereich von 3 bis 5 K und/oder von flüssigem Helium vorgesehen sein. Der supraleitende Magnet kann insbesondere thermisch über einen Wärmeleitkontakt mit der zweiten Stufe der Kühlung verbindbar sein. Das erste Kühlsystem kann einen Kühler umfassen. Das erste Kühlsystem kann einen Kompressor umfassen. Der Kompressor kann dazu ausgestaltet sein, das Kühlmittel, insbesondere Helium, zu komprimieren und dann dem Kühler zuzuführen.

Das zweite Kühlsystem kann grundsätzlich ebenfalls analog zu bekannten Kühlkreisläufen für supraleitende Magnete aufgebaut sein bzw. entsprechende Komponenten aufweisen, wobei das zweite Kühlsystem dazu ausgestaltet ist, mit Energie von dem Magneten betrieben zu werden. Das zweite Kühlsystem kann als Notkühlkreislauf bzw. Notkühlsystem angesehen werden. Das zweite Kühlsystem kann einen Kühler umfassen. Das zweite Kühlsystem kann einen Kompressor umfassen. Kühler und/oder Kompressor des zweiten Kühlsystems können analog zu Kühler und/oder Kompressor des ersten Kühlsystems vorgesehen sein. Das zweite Kühlsystem ist dazu ausgestaltet, die Kühlung für den supraleitenden Magneten aufrechtzuerhalten und dazu mit in dem supraleitenden Magneten gespeicherter Energie betrieben zu werden. Das zweite Kühlsystem kann insbesondere dazu ausgestaltet sein, ein Aufrechterhalten einer Temperatur des Magneten unterhalb dessen Sprungtemperatur zu ermöglichen. Das Verwenden der Energie des Magneten an sich ist bereits vorteilhaft, weil somit eine Kühlung auch bei einem Stromausfall fortgesetzt werden kann. Somit kann ein Herunterfahren des Magneten langsamer geschehen, als es ansonsten wegen der ausfallenden Kühlung notwendig wäre. Vorteilhafterweise kann die Energie im Magneten durch die Versorgung des zweiten Kühlsystems damit sicher und gleichzeitig effizient abgebaut werden, was gerade für Magnete mit großer Feldstärke (z.B. im Bereich ab 3 Tesla oder ab 5 Tesla) vorteilhaft ist. Durch die Verwendung speziell des zweiten Kühlsystems kommen weitere wichtige Vorteile hinzu. Während es grundsätzlich auch denkbar wäre, das erste Kühlsystem durch die Energie des Magneten zu versorgen, kann der Energiebedarf des zweiten Kühlsystems geringer gehalten werden, weil lediglich ein Aufrechterhalten der gekühlten Temperatur des Magneten benötigt wird. Optional kann das zweite Kühlsystem eine geringere maximale Kühlleistung als das erste Kühlsystem aufweisen. Beispielsweise kann das zweite Kühlsystem eine maximale Kühlleistung aufweisen, die nicht ausreichend wäre, um ein Herunterkühlen des Magneten auf eine Betriebstemperatur effektiv zu ermöglichen. Vorteilhafterweise kann das zweite Kühlsystem somit mit weniger Energie auskommen, insbesondere weil es ausreichend ist, wenn das zweite Kühlsystem den Magneten auf seiner Betriebstemperatur halten kann. Darüber hinaus kann das zweite Kühlsystem unabhängig von Fehlern, die das erste Kühlsystem betreffen, sein. Vorteilhafterweise kann eine Energieversorgung des zweiten Kühlsystems vorgesehen sein, die unabhängig von einer externen Energieversorgung ist. Beispielsweise kann das zweite Kühlsystem von einem Stromausfall oder einem Kurzschluss, der/die das erste Kühlsystem betreffen, somit unbeeinträchtigt bleiben. Auch bei einem Fehler einer Komponente des ersten Kühlsystems (z.B. Ausfall eines Kompressors des ersten Kühlsystems) kann das zweite Kühlsystem weiter funktionieren.

Gemäß einer Ausführungsform ist das zweite Kühlsystem dazu ausgestaltet, anfallende Wärme seiner Komponenten an eine Umgebung abzugeben. Beispielsweise kann das zweite Kühlsystem Komponenten umfassen, die eine passive Kühlung ermöglichen. Die Komponenten können passive Kühlmittel und/oder Wärmeleiter umfassen. Insbesondere kann die thermische Kapazität und der thermische Widerstand zur Umgebung des ersten Kühlsystems und/oder angeschlossener der angeschlossenen Systemkomponenten zur Abfuhr von Wärme genutzt werden.

Gemäß einer Ausführungsform umfasst das zweite Kühlsystem eine interne Wasserkühlung mit einer Wasserpumpe, wobei die Wasserkühlung dazu ausgestaltet ist, zumindest eine Komponente des zweiten Kühlsystems zu kühlen. Die zumindest eine Komponente kann insbesondere einen Kompressor des zweiten Kühlsystems umfassen. Eine interne Wasserkühlung ist insbesondere so zu verstehen, dass die Wasserkühlung nicht abhängig ist von einem äußeren Wasseranschluss. Die interne Wasserkühlung kann dazu ausgestaltet sein, Wasser in dem zweiten Kühlsystem umzuwälzen. Durch das Umwälzen von Wasser kann eine bessere Abgabe von Wärme ermöglicht werden. Die interne Wasserkühlung kann insbesondere ebenfalls durch die Energie des Magneten betrieben werden. Vorteilhafterweise ist durch die interne Wasserkühlung eine effiziente Wärmeabgabe möglich, ohne von äußeren Versorgern, z.B. einem externen Wasseranschluss abhängig zu sein. Beispielsweise könnte es sein, dass bei einem Stromausfall auch eine externe Wasserkühlung ausfällt. Davon kann das zweite Kühlsystem vorteilhafterweise unabhängig sein. Es wurde festgestellt, dass ein komplettes Kühlsystem ausreichend viel Wärmekapazität aufweist, um zumindest vorübergehend, das heißt im Rahmen des Betriebs des zweiten Kühlsystems genügend Wärme aufnehmen zu können. Durch die Wasserkühlung kann eine ausreichende Verteilung der Wärme weg von sich erhitzenden Komponenten des Kühlsystems ermöglicht werden. Optional kann die interne Kühlung dazu ausgestaltet sein, auch Wärme an das erste Kühlsystem abzugeben.

Gemäß einer Ausführungsform umfasst die Kühlvorrichtung ein Steuergerät, das dazu ausgestaltet ist, wiederholt, insbesondere zyklisch in vorbestimmten Zeitintervallen, eine Funktionalität des zweiten Kühlsystems zu überprüfen. Die vorbestimmten Zeitintervalle können insbesondere abhängig von einer Fehlereintrittswahrscheinlichkeit für einen Fehler des zweiten Kühlsystems eingestellt sein. Die Fehlereintrittswahrscheinlichkeit bezeichnet insbesondere die Wahrscheinlichkeit, dass ein Fehler innerhalb eines Zeitintervalls auftritt. Eine Abhängigkeit von einer Fehlereintrittswahrscheinlichkeit kann demnach bedeuten, dass die Funktionalität in Zeitintervallen geprüft wird, in denen die Fehlereintrittswahrscheinlichkeit unterhalb einem definierten Schwellwert liegt. Beispielsweise können die Zeitintervalle einem oder mehreren Tagen oder einer oder mehreren Wochen entsprechen. Beispielsweise kann eine Funktionalität täglich oder wöchentlich überprüft werden. Durch das Überprüfen der Funktionalität kann das zweite Kühlsystem erstfehlersicher sein. Damit kann vorteilhafterweise die Wahrscheinlichkeit ausreichend erhöht werden, dass bei einem Ausfall des ersten Kühlsystems zumindest das zweite Kühlsystem funktioniert.

Gemäß einer Ausführungsform ist die Kühlvorrichtung dazu ausgestaltet, bei einem Ausfall des ersten Kühlsystems eine Fehleranzeige auszugeben und/oder einen Alarm zu initiieren. Insbesondere kann es vorgesehen sein, bei einem Ausfall des ersten Kühlsystems Maßnahmen zu einer Korrektur des Ausfalls einzuleiten. Der Ausfall kann mit Hilfe der Fehleranzeige und/oder des Alarms erkannt werden. Sind Fehler die zu dem Ausfall führen, beispielsweise Fehler in der Energieversorgung oder Defekte Komponenten, behoben, kann insbesondere direkt wieder damit begonnen werden, den Magneten auf seine Systemfeldstärke zu bringen. Vorteilhafterweise kann der Magnet durch die Kühlung des zweiten Kühlsystems dann noch ausreichend gekühlt sein, sodass ein erneutes Herunterkühlen des Magneten nicht notwendig ist.

Gemäß einer Ausführungsform ist eine Energieversorgung des zweiten Kühlsystems über zumindest eine elektrische Leitung mit einem elektrischen Stromkreis des supraleitenden Magneten verbindbar. Die Kühlvorrichtung kann insbesondere dazu ausgestaltet sein, bei einem Ausfall des ersten Kühlsystems den Stromfluss eines verbundenen supraleitenden Magneten kontrolliert herunterzufahren und/oder einen dadurch generierten Strom zum Betreiben des ersten Kühlsystems einzusetzen. Die Kühlvorrichtung kann insbesondere ein Steuergerät umfassen, welches das kontrollierte Herunterfahren des Stromflusses zu steuern. Das Steuergerät kann auch Teil eines übergeordneten Magnetsystems sein, welches den supraleitenden Magneten umfasst.

Gemäß einer Ausführungsform umfasst das zweite Kühlsystem einen elektrischen Stromeingang und ist dazu ausgestaltet, mit Gleichstrom betrieben zu werden, insbesondere mit Gleichstrom, der von dem supraleitenden Magneten bezogen wird. Insbesondere kann das gesamte zweite Kühlsystem dazu ausgestaltet sein, mit Gleichstrom betrieben zu werden. Beispielsweise kann auch eine interne Wasserkühlung des zweiten Kühlsystems dazu ausgestaltet sein, mit dem Gleichstrom betrieben werden.

Gemäß einer Ausführungsform umfassen das erste Kühlsystem und das zweite Kühlsystem jeweils einen Kaltkopf oder zusammen einen gemeinsamen Kaltkopf zum Verflüssigen eines Kühlmittels, insbesondere zum Verflüssigen von Helium, mit dem der supraleitende Magnet gekühlt wird. Mit anderen Worten kann es einerseits vorgesehen sein, dass das erste Kühlsystem einen ersten Kaltkopf umfasst und dass das zweite Kühlsystem einen zweiten Kaltkopf umfasst. Alternativ kann es vorgesehen sein das das erste Kühlsystem und das zweite Kühlsystem dazu ausgestaltet sind, einen Kaltkopf gemeinsam zu nutzen bzw. zu betreiben. Jeweils ein Kaltkopf für jedes der Kühlsysteme kann den Vorteil haben, dass auch beim Ausfall des Kaltkopf des ersten Kühlsystems eine Kühlung weiter aufrechterhalten werden kann mithilfe des Kaltkopf des zweiten Kühlsystems. Ein gemeinsamer Kaltkopf kann hingegen den Vorteil haben, dass Platz und Material eingespart werden kann, wobei gerade der Ausfall des Kaltkopfes als relativ gering angesehen werden kann. Der gemeinsame Kaltkopf kann beispielsweise als Dual-Source-Kaltkopf betrieben werden. Entsprechend ist der gemeinsame Kaltkopf sowohl Teil des ersten Kühlsystems als auch Teil des zweiten Kühlsystems.

Gemäß einer Ausführungsform umfasst die Kühlvorrichtung einen Kühlmittelbehälter, insbesondere Heliumbehälter, der dazu ausgestaltet ist, verflüssigtes Kühlmittel zu beinhalten und in Wärmeleitkontakt mit dem supraleitenden Magneten gebracht zu werden, wobei die zwei Kaltköpfe des jeweils einen Kaltkopfs oder der gemeinsame Kaltkopf dazu ausgestaltet sind/ist, einem Verdampfen des verflüssigten Kühlmittels entgegenzuwirken und/oder verdampftes Kühlmittel zu verflüssigen. Das verflüssigte Kühlmittel kann insbesondere verflüssigtes Helium sein. Der Kühlmittelbehälter ist vorzugsweise dazu ausgestaltet, in der Nähe des supraleitenden Magneten angeordnet zu werden. Insbesondere kann es vorgesehen sein, dass der Kühlmittelbehälter und der Kaltkopf so ausgestaltet sind, dass sie näher an dem supraleitenden Magneten angeordnet werden können, als weitere Komponenten des ersten und zweiten Kühlsystems, insbesondere jeweils ein Kühler und ein Kompressor des ersten und zweiten Kühlsystems. Gemäß einer Ausführungsform umfasst das erste Kühlsystem und/oder das zweites Kühlsystem jeweils einen Wärmetauscher. Der Wärmetauscher kann insbesondere jeweils Teil einer Wasserkühlung sein und/oder mit einer Wasserkühlung verknüpft sein.

Ein weiterer Aspekt der Erfindung ist ein Magnetsystem umfassend einen supraleitenden Magneten mit einer Magnetspule und eine Kühlvorrichtung wie hierin beschrieben. Das Magnetsystem umfasst einen Kühlmittelbehälter, insbesondere Heliumbehälter, der dazu ausgestaltet ist, verflüssigtes Kühlmittel zu beinhalten, und wobei ein Wärmeleitkontakt zwischen dem Inhalt des Kühlmittelbehälters und dem supraleitenden Magneten besteht. Das verflüssigte Kühlmittel kann insbesondere verflüssigtes Helium sein. Das erste Kühlsystem und das zweite Kühlsystem sind jeweils dazu ausgestaltet, einem Verdampfen des verflüssigten Kühlmittels entgegenzuwirken und/oder verdampftes Kühlmittel zu verflüssigen. Alle Vorteile und Merkmale der Kühlvorrichtung können analog auf das Magnetsystem übertragen werden und umgekehrt. Vorzugsweise kann der supraleitende Magnet in einer Vakuumkammer angeordnet sein. Beispielsweise kann die Vakuumkammer aus Stahl gefertigt sein. Vorzugsweise ist der Kühlmittelbehälter außerhalb der Vakuumkammer angeordnet. Der Wärmeleitkontakt kann über eine isolierte Durchführung von dem Kühlmittelbehälter zu dem supraleitenden Magneten führen. Vorzugsweise ist die Vakuumkammer geerdet und der Magnet hat einen Erdungskontakt über die Vakuumkammer. Es kann eine zweistufige Kühlung des Magneten vorgesehen sein. Die zweite Stufe ist insbesondere dazu ausgestaltet, eine Temperatur bereitzustellen, die unterhalb der Sprungtemperatur des supraleitenden Magneten liegt. Die erste Stufe ist insbesondere dazu ausgestaltet eine Vorkühlung auf eine etwas höhere Temperatur als die zweite Stufe bereitzustellen. Bei einer zweistufigen Kühlung kann beispielsweise eine erste Stufe auf eine Temperatur im Bereich von 50-80 K und/oder der Temperatur von flüssigem Stickstoff und eine zweite Stufe auf eine Temperatur im Bereich von 3 bis 5 K und/oder von flüssigem Helium vorgesehen sein. Der Magnet kann insbesondere thermisch über den Wärmeleitkontakt mit der zweiten Stufe der Kühlung verbunden sein. Vorzugsweise ist zumindest eine Abschirmung, insbesondere sind zumindest zwei Abschirmungen, gegen thermische Strahlung zwischen dem Magneten und den Außenwänden der Vakuumkammer vorgesehen. Eine erste, äußere, Abschirmung kann thermisch mit der ersten Stufe der Kühlung verknüpft sein und eine zweite, innere, Abschirmung kann thermisch mit der zweiten Stufe der Kühlung verknüpft sein. Das Magnetsystem kann ein Steuergerät umfassen. Das Steuergerät kann dazu ausgestaltet sein, das erste Kühlsystem, das zweite Kühlsystem und/oder den supraleitenden Magneten zu steuern. Insbesondere kann das Steuergerät dazu ausgestaltet sein, dass zweite Kühlsystem zu aktivieren, wenn das erste Kühlsystem ausfällt. Das Steuergerät kann dazu ausgestaltet sein, eine Funktionsfähigkeit des ersten Kühlsystems zu überwachen, und das zweite Kühlsystem zu aktivieren, sobald das erste Kühlsystem ausfällt. Das Steuergerät kann dazu ausgestaltet sein, bei einem Ausfall des ersten Kühlsystems, ein kontrolliertes Herunterfahren des supraleitenden Magneten zu initiieren, und die Energie des supraleitenden Magneten, die insbesondere durch das Herunterfahren des supraleitenden Magneten gewonnen wird, in das zweite Kühlsystem zum Betreiben des zweiten Kühlsystems zu speisen. Das Steuergerät kann dazu ausgestaltet sein, wiederholt, insbesondere zyklisch in vorbestimmten Zeitintervallen, eine Funktionalität des zweiten Kühlsystems zu überprüfen. Das zweite Steuergerät kann dazu ausgestaltet sein, bei einem Ausfall des ersten Kühlsystems eine Fehleranzeige auszugeben und/oder einen Alarm zu initiieren. Das Steuergerät umfasst vorzugsweise eine unterbrechungsfreie Stromversorung (USV). Das Steuergerät kann beispielsweise eine eigene Energieversorgung und/oder Not-Energieversorgung umfassen und/oder ebenfalls mit Energie aus dem Magneten betreibbar sein. Eine Notenergieversorgung kann beispielsweise eine Batterie, ein Akku und/oder ein Notstromaggregat sein. Optional kann das Magnetsystem so ausgestaltet sein, dass bei einem Ausfall des zweiten Kühlsystems und/oder bei einem Ausfall des Steuergeräts, der Magnet automatisch herunterfährt und mit der Energie des herunterfahrenden Magneten automatisch das zweite Kühlsystem versorgt wird. Vorzugsweise kann der Kühlmittelbehälter und/oder zumindest ein Kaltkopf näher an dem supraleitenden Magneten angeordnet sein als jeweils ein Kühler des ersten und/oder zweiten Kühlsystems.

Gemäß einer Ausführungsform ist eine Energieversorgung des zweiten Kühlsystems über zumindest eine elektrische Leitung mit einem elektrischen Stromkreis des supraleitenden Magneten verbunden, wobei das Magnetsystem dazu ausgestaltet ist, bei einem Ausfall des ersten Kühlsystems den elektrischen Stromfluss durch den supraleitenden Magneten kontrolliert herunterzufahren und einen dadurch generierten elektrischen Strom zum Betreiben des ersten Kühlsystems einzusetzen. Das kontrollierte Herunterfahren des Stromflusses kann insbesondere durch das Steuergerät des Magnetsystems kontrolliert werden.

Gemäß einer Ausführungsform ist das Magnetsystem dazu ausgestaltet, den elektrischen Strom zum Betreiben des zweiten Kühlsystems als Gleichstrom bereitzustellen. Insbesondere kann das Magnetsystem so ausgestaltet sein, auch eine Wasserkühlung des ersten Kühlsystems mit Gleichstrom zu betreiben. Es kann vorgesehen sein, dass das Magnetsystem dazu ausgestaltet ist, dass erste Kühlsystem mit Wechselstrom zu betreiben.

Gemäß einer Ausführungsform umfasst das Magnetsystem einen Gleichstromschaltung, wobei die Gleichstromschaltung eine bidirektionale Magnetstromversorgung umfasst, die dazu ausgestaltet ist, in einem ersten Modus elektrischen Strom in die Magnetspule einzuspeisen und in einem zweiten Modus elektrischen Strom der Magnetspule zu entnehmen und in das zweite Kühlsystem einzuspeisen. Das Magnetsystem kann einen Gleichrichter zum Einspeisen von Gleichstrom in die Gleichstromschaltung umfassen, insbesondere den Gleichstrom aus einer Wechselstromquelle kommend einzuspeisen. Insbesondere kann das Magnetsystem dazu ausgestaltet sein, dass der erste Modus aktiv ist, solange das erste Kühlsystem funktioniert, und dass der zweite Modus aktiv ist, sobald das erste Kühlsystem ausfällt. Die Gleichstromschaltung kann derart ausgestaltet sein, dass das zweite Kühlsystem unabhängig von weiteren Komponenten des Magnetsystems, insbesondere den Komponenten des ersten Kühlsystems und/oder von Komponenten, die nicht direkt an die Gleichstromschaltung angeschlossen sind. Optional kann das Magnetsystem und/oder die Gleichstromschaltung so ausgestaltet sein, dass bei einem Ausfall des zweiten Kühlsystems und/oder bei einem Ausfall des Steuergeräts des Magnetsystems, der Magnet automatisch herunterfährt und mit dem Strom des herunterfahrenden Magneten automatisch das zweite Kühlsystem versorgt wird. Dies kann insbesondere durch die bidirektionale Magnetstromversorgung ermöglicht werden. Die Magnetstromversorgung kann dazu ausgestaltet sein, den supraleitenden Magneten mit niedriger Spannung und hoher Stromstärke zu versorgen. Beispielsweise kann eine Spannung für den Magneten im Bereich von 5V und eine Stromstärke bei zumindest 500A liegen.

Gemäß einer Ausführungsform ist das Magnetsystem dazu konfiguriert, bei einem Ausfall des ersten Kühlsystems den supraleitenden Magneten gezielt so herunterzufahren und ihm gezielt so elektrische Energie zu entnehmen, dass eine erzeugte Spannung zur Versorgung des zweiten Kühlsystems dem Bedarf zum Betreiben des zweiten Kühlsystems entspricht. Das Magnetsystem und/oder das Kühlsystem kann insbesondere ein Steuergerät umfassen das dazu ausgestaltet ist, die Entnahme der Energie zu steuern. Insbesondere kann das Steuergerät des Magnetsystems und/oder der Kühlvorrichtung dazu konfiguriert sein, dass es bei einem Ausfall des ersten Kühlsystems eine Entnahme von Energie aus dem supraleitenden Magneten gemäß einem Bedarf des zweiten Kühlsystems regelt. Insbesondere kann das Steuergerät so konfiguriert sein, die Entnahme von Energie aus dem supraleitenden Magneten so zu regeln, dass nur so viel Energie von dem supraleitenden Magneten entnommen wird, wie für einen Betrieb des zweiten Kühlsystems benötigt wird. Beispielsweise kann eine Versorgungsspannung für das zweite Kühlsystem durch einen einstellbaren Widerstand gesteuert werden. Dabei kann beispielsweise ein Spannungsabfall über den Widerstand so eingestellt werden, dass das bei einem bestimmten Stromfluss gerade die benötigte Menge an Leistung entnommen wird. Insbesondere kann es vorgesehen sein, bei mit der Zeit erwartbar sinkender Stromstärke beim Herunterfahren des Magneten die Spannung mit der Zeit zu erhöhen.

Gemäß einer Ausführungsform umfasst das Magnetsystem zumindest eine passive Komponente zum Abbauen von Energie des supraleitenden Magneten bei einem Ausfall des ersten Kühlsystems, insbesondere von Energie, die nicht zum Betreiben des ersten Kühlsystems verwendet wird und/oder verwendbar ist. Die passive Komponente kann insbesondere Teil der Gleichstromschaltung des Magnetsystems wie hierin beschrieben sein. Die passive Komponente kann insbesondere einen Widerstand umfassen. Die passive Komponente kann optional als "Run-Down-Load" bezeichnet werden. Beispielsweise kann die passive Komponente zumindest eine Leistungsdiode, vorzugsweise mehrere Leistungsdioden, umfassen. Insbesondere kann die passive Komponente eine Reihenschaltung von Leistungsdioden umfassen. Durch die zumindest eine Leistungsdiode kann, bei Stromfluss von den Magneten her durch die Leistungsdiode, ein Spannungsabfall erzeugt werden, wodurch die zumindest eine Leistungsdioden Energie, insbesondere in Form von Wärme, aufnehmen kann. Beispielsweise können die Leistungsdioden auf einem Aluminiumblock angeordnet sein. Vorzugsweise ist der Aluminiumblock so ausgestaltet, dass er ausreichend Wärmekapazität hat, um eine Energie des supraleitenden Magneten beim Herunterfahren des supraleitenden Magneten aufzunehmen. Das Magnetsystem kann optional eine, insbesondere aktive, Kühlung für die zumindest eine passive Komponente, beispielsweise eine aktive Luftkühlung, umfassen. Das Magnetsystem kann so ausgestaltet sein, dass die aktive Kühlung durch das zweite Kühlsystem betrieben werden kann. Eine Kühlung für die zumindest eine passive Komponente kann insbesondere bei Magnetsystem für hohe Feldstärken, beispielsweise für Feldstärken ab drei Tesla, vorgesehen sein. Bei Magnetsystem mit großen Feldstärken kann die Hitzeentwicklung in der passiven Komponente aufgrund der großen Energie, die in dem Magneten beim Betrieb gespeichert ist, besonders groß sein, weshalb hier eine, insbesondere aktive, Kühlung besonders vorteilhaft sein kann. Vorzugsweise ist die zumindest eine passive Komponente beanstandet zu dem supraleitenden Magneten angeordnet. Durch eine Beabstandung kann insbesondere verhindert werden, dass in der passiven Komponente erzeugte Wärme auf den Magneten wirkt. Somit entstehen im Magnetraum keine erhöhten Temperaturen durch den Abbau der magnetischen Energie bzw. deren Wandlung in Wärmeenergie. Dies ist gerade bei einem trockenen Magneten, d. h. bei einem Magneten der nicht in einem Heliumbad angeordnet ist, vorteilhaft, weil die Wärmekapazität des Kühlmittels, insbesondere Heliums, bei einem trockenen Magneten gegebenenfalls nicht ausreicht, um die passive Komponente zu kühlen. Die passive Komponente kann dazu ausgestaltet sein, dass, wenn die Energie in den Magneten nicht mehr ausreichend ist, um das zweite Kühlsystem zu betreiben, die verbleibende Energie über die passive Komponente abgebaut wird bzw. werden kann. Vorteilhafterweise kann mit der passiven Komponente eine Sicherheit des Systems erzielt werden, auch wenn das erste Kühlsystem nicht rechtzeitig wiederhergestellt werden kann. Die passive Komponente kann optional auch dazu vorgesehen sein, möglicherweise überschüssige entstehende Energie, die beim Betreiben des zweiten Kühlsystems von den zweiten Kühlsystem nicht verwendet bzw. benötigt wird, abzubauen. Indem es vorgesehen ist, dass ein Großteil der Energie des Magneten dazu verwendet wird, das zweite Kühlsystem zu betreiben, kann ein Gewicht und Volumen der zumindest einen passiven Komponente relativ gering ausgestaltet werden. Die zumindest eine passive Komponente kann in Reihe zwischen einem Stromausgang des supraleitenden Magneten und einem Stromeingang des zweiten Kühlsystems angeordnet sein.

Ein weiterer Aspekt der Erfindung ist ein Magnetresonanztomographiesystem umfassend ein Magnetsystem wie hierin beschrieben und/oder eine Kühlvorrichtung wie hierin beschrieben, wobei der supraleitende Magnet insbesondere der Hauptmagnet des Magnetresonanztomographiesystems ist. Alle Vorteile und Merkmale der Kühlvorrichtung und des Magnetsystems können analog auf das Magnetresonanztomographiesystem übertragen werden und umgekehrt. Der supraleitendende Magnet kann insbesondere außen an einem Untersuchungstunnel des Magnetresonanztomographiesystems angeordnet sein bzw. Teil des Untersuchungstunnels sein. Insbesondere kann der supraleitende Magnet als Magnetspule um den Untersuchungsbereich des Untersuchungstunnels herum angeordnet sein, vorzugsweise innerhalb einer Vakuumkammer, die ebenfalls um den Untersuchungstunnel herum angeordnet ist. Insbesondere können Magnetspule und Vakuumkammer jeweils zylinderförmig um den Untersuchungsbereich herum angeordnet sein.

Ein weiterer Aspekt der Erfindung ist ein Verfahren zum Aufrechterhalten einer Kühlung eines supraleitenden Magneten mit einer Magnetspule, insbesondere eines Magneten eines Magnetresonanztomographiesystems, bei Ausfall eines ersten Kühlsystems für den Magneten umfassend die folgenden Schritte:
- kontrolliertes Herunterfahren des elektrischen Stroms des supraleitenden Magneten;
- Generieren einer Stromversorgung für ein zweites Kühlsystem unter Verwendung von elektrischem Strom, der dem supraleitenden Magneten beim Herunterfahren entnommen wird;
- Aufrechterhalten einer Kühlung des supraleitenden Magneten durch das zweite Kühlsystem, insbesondere Betreiben eines Kaltkopfs für einen Kühlmittelbehälter zum Kühlen des Magneten mit dem zweiten Kühlsystem;
wobei insbesondere eine Kühlvorrichtung wie hierin beschrieben und/oder ein Magnetsystem wie hierin beschrieben verwendet wird. Alle Vorteile und Merkmale der Kühlvorrichtung, des Magnetsystems und des Magnetresonanztomographiesystems können analog auf das Verfahren übertragen werden und umgekehrt. Optional kann bei einem Ausfall des ersten Kühlsystems eine Fehleranzeige ausgegeben und/oder einen Alarm initiiert werden. Vorzugsweise kann bei einem Ausfall des ersten Kühlsystems eine Wiederherstellung des ersten Kühlsystems gestartet werden. Die Stromversorgung für das zweite Kühlsystem kann insbesondere als Gleichstromversorgung bereitgestellt werden. Vorzugsweise wird der supraleitende Magnet gezielt so herunterzufahren und es wird ihm gezielt so viel elektrische Energie bzw. elektrischer Strom entnommen, dass eine erzeugte Spannung zur Versorgung des zweiten Kühlsystems dem Bedarf zum Betreiben des zweiten Kühlsystems entspricht.

Gemäß einer Ausführungsform wird, während das erste Kühlsystem noch funktioniert, das zweite Kühlsystem in vorbestimmten Zeitintervallen auf seine Funktionsfähigkeit getestet, wobei die vorbestimmten Zeitintervalle abhängig von einer Fehlereintrittswahrscheinlichkeit für einen Fehler des zweiten Kühlsystems eingestellt sind. Insbesondere können somit Tests innerhalb der Fehlereintrittswahrscheinlichkeit vorgesehen sein. Damit kann eine Erstfehlersicherheit erzielt werden. Beispielsweise kann ein zyklisches Testen wöchentlich oder täglich vorgesehen sein.

Ein weiterer Aspekt der Erfindung ist ein Computerprogrammprodukt umfassend Befehle, die bei der Ausführung des Programms durch ein Steuergerät eines Magnetsystems oder eines Magnetresonanztomographiesystems dieses veranlassen, die Schritte des Verfahrens wie hierin beschrieben auszuführen. Alle Vorteile und Merkmale des Verfahrens können analog auf das Computerprogrammprodukt übertragen werden und umgekehrt. Das Computerprogrammprodukt kann beispielsweise auf einem computerlesbaren Speichermedium, insbesondere nichtflüchtigen Speichermedium, gespeichert sein. Das Speichermedium kann beispielsweise eine Festplatte, eine SSD, ein Flash-speicher, ein Online-Server, etc., sein.

Ein weiterer Aspekt der Erfindung ist ein Steuergerät für ein Magnetsystem oder ein Magnetresonanztomographiesystem, das dazu ausgestaltet ist, das Magnetsystem bzw. das Magnetresonanztomographiesystem die Schritte des Verfahrens wie hierin beschrieben ausführen zu lassen. Alle Vorteile und Merkmale des Verfahrens können analog auf das Steuergerät übertragen werden und umgekehrt.

Ein weiterer Aspekt der Erfindung ist eine Verwendung eines zweiten Kühlsystems für ein Magnetsystem, insbesondere ein Magnetresonanztomographiesystem, mit einem supraleitenden Magneten, um bei einem Ausfall eines ersten Kühlsystems des supraleitenden Magneten eine Kühlung des supraleitenden Magneten aufrechtzuerhalten, wobei das zweite Kühlsystem bei dem Ausfall des ersten Kühlsystems mit in dem supraleitenden Magneten gespeicherter Energie betrieben wird. Das erste und das zweite Kühlsystem können insbesondere dem Kühlsystem wie hierin beschrieben entsprechen. Vorzugsweise kann eine Kühlvorrichtung wie hierin beschrieben verwendet werden. Alle Vorteile und Merkmale der Kühlvorrichtung, des Magnetsystems, des Magnetresonanztomographiesystems und des Verfahrens können analog auf die Verwendung übertragen werden und umgekehrt.

Alle hierin beschriebenen Ausführungsformen können miteinander kombiniert werden, soweit nicht explizit etwas anderes angegeben ist.

Im Folgenden werden Ausführungsformen mit Bezug auf die beigefügten Figuren beschrieben.
Fig. 1 zeigt ein Magnetsystem mit einer Kühlvorrichtung gemäß einer Ausführungsform der Erfindung,
Fig. 2 zeigt ein Magnetresonanztomographiesystem gemäß einer Ausführungsform der Erfindung mit einem erfindungsgemäßen Magnetsystem wie beispielsweise in Figur 1 gezeigt, und
Fig. 3 zeigt ein Flussdiagramm eines Verfahrens zum Aufrechterhalten einer Kühlung eines supraleitenden Magneten bei Ausfall eines ersten Kühlsystems mit einer Magnetspule gemäß einer Ausführungsform der Erfindung.

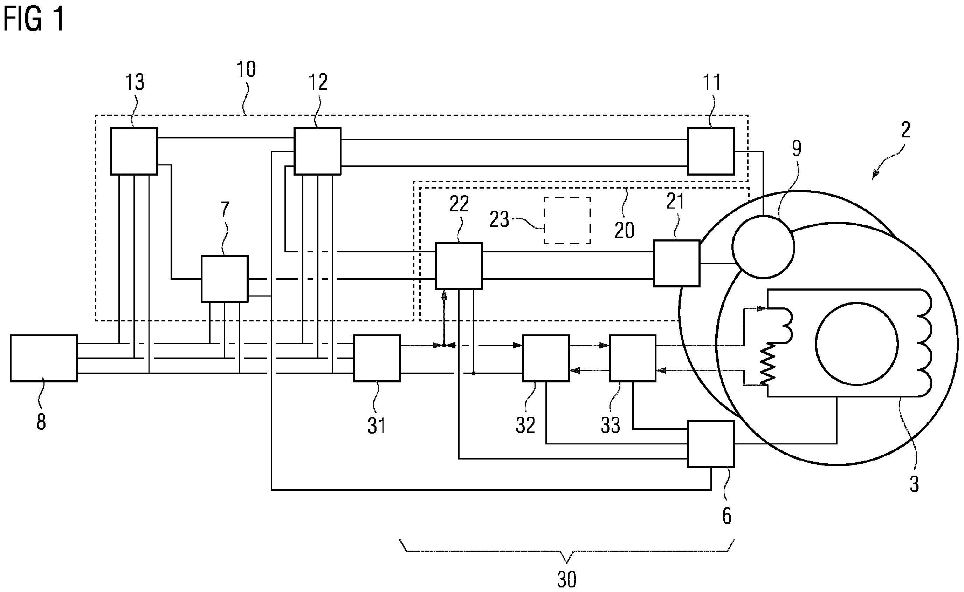

Figur 1 zeigt ein Magnetsystem mit einer Kühlvorrichtung gemäß einer Ausführungsform der Erfindung. Das Magnetsystem umfasst einen supraleitenden Magneten 2 und die Kühlvorrichtung. Die Kühlvorrichtung umfasst ein erstes Kühlsystem 10, und ein zweites Kühlsystem 20. Das Magnetsystem wird durch eine Steuervorrichtung 6 gesteuert. Das Magnetsystem kann insbesondere Teil eines Magnetresonanztomographiesystems sein, wobei der Magnet 2 vorzugsweise der Hauptmagnet des Magnetresonanztomographiesystems sein kann. Der supraleitende Magnet umfasst eine Magnetspule 3 mit Leitern die bei ausreichender Kühlung supraleitend sind und ist in einer Vakuumkammer angeordnet (hier nicht explizit gezeigt). Sowohl das erste Kühlsystem 10 als auch das zweite Kühlsystem 20 sind dazu ausgestaltet, den supraleitenden Magneten 2 zu kühlen. Dazu umfassen das erste Kühlsystem 10 und das zweite Kühlsystem 20 einen gemeinsamen Heliumbehälter 9 zur Aufnahme von flüssigem Helium. Der Heliumbehälter 9 ist in der Nähe des supraleitenden Magneten 2 angeordnet und ist mit dem supraleitenden Magneten 2 über zumindest einen Wärmekontakt verbunden. Durch den Wärmekontakt mit dem verflüssigten Helium wird der supraleitende Magnet 2 auf einer Temperatur unterhalb seiner Sprungtemperatur gehalten. Vorzugsweise ist der Heliumbehälter 9 außerhalb der Vakuumkammer des Magneten 2 angeordnet. Der Wärmeleitkontakt kann über eine isolierte Durchführung zu von dem Kühlmittelbehälter zu dem supraleitenden Magneten führen. Vorzugsweise ist die Vakuumkammer geerdet und der Magnet hat einen Erdungskontakt über die Vakuumkammer.

Über einen Transformator 8 wird dem Magnetsystem elektrische Energie mit einer geeigneten Spannung zugeführt. Über den Transformator 8 wird sowohl das erste Kühlsystem 10 als auch der supraleitende Magnet 2 mit Strom versorgt. Das erste Kühlsystem 10 wird in dieser Ausführungsform durch Wechselspannung betrieben. Das Magnetsystem umfasst für die Versorgung des supraleitenden Magneten 2 eine Gleichstromschaltung 30 und einen Gleichrichter 31, der Wechselspannung in Gleichspannung für die Gleichstromschaltung 30 umwandelt. Innerhalb der Gleichstromschaltung 30 ist eine Magnetstromversorgung 32 vorgesehen, die dazu ausgestaltet ist, elektrischen Strom in die Magnetspule 3 des supraleitenden Magneten 2 einzuspeisen. Über den Transformator 8 können zudem weitere Systemkomponenten 7 versorgt werden. Während des normalen Betriebs des supraleitenden Magneten 2 wird der supraleitende Magnet 2 durch das erste Kühlsystem 10 gekühlt, indem das Helium in dem Heliumbehälter 9 durch den ersten Kaltkopf 11 gekühlt bzw. verflüssigt wird, und das zweite Kühlsystem 20 ist im Wesentlichen inaktiv. Es kann vorgesehen sein, das zweite Kühlsystem 20 gelegentlich, insbesondere zyklisch in regelmäßigen Abständen, auf seine Funktionsfähigkeit zu testen.

Um einem Verdampfen des flüssigen Heliums entgegenzuwirken bzw. um verdampftes Helium wieder zu verflüssigen sind zwei Kaltköpfe 11,21 vorgesehen. Ein erster Kaltkopf 11 ist Teil des ersten Kühlsystems 10 und ein zweiter Kaltkopf 21 ist Teil des zweiten Kühlsystems 20. Alternativ kann es auch vorgesehen sein, dass das erste Kühlsystem 10 und das zweite Kühlsystem 20 sich einen gemeinsamen Kaltkopf teilen, der in einer Dual-Source-Ausführung vorgesehen ist, d. h. der sowohl von den ersten Kühlsystem 10 als auf einem zweiten Kühlsystem 20 betrieben werden kann. Während eines normalen Betriebs des supraleitenden Magneten 2 ist es vorgesehen, dass das Helium in dem Heliumbehälter 9 durch das erste Kühlsystem 10 verflüssigt wird bzw. gekühlt wird. Das erste Kühlsystem 10 umfasst dazu einen Kühler 12 zum Kühlen des Kaltkopfes 11. Weiterhin umfasst das erste Kühlsystem vorzugsweise einen Kompressor (hier nicht gezeigt), der dazu ausgestaltet ist, Helium zu komprimieren und für den Kühler 12 bereitzustellen, der dann das Helium auf herunterkühlt (typischerweise auf ca. 3-5K), sodass eine Temperatur unterhalb der Sprungtemperatur des Materials der Magnetspule 3 erreicht wird. Das erste Kühlsystem 10 umfasst ferner einen Wärmetauscher 13 mit dem, insbesondere basierend auf einer Wasserkühlung, Wärme von den ersten Kühlsystem 10 abgeführt werden kann.

Sobald die Temperatur des supraleitenden Magneten mit Hilfe des ersten Kühlsystems 10 stabil auf eine entsprechende Temperatur unterhalb der Sprungtemperatur eingestellt ist, wird der supraleitende Magnet mit Strom versorgt. Dazu kann insbesondere die Größe des Stroms durch die Magnetspule 3 graduell hochgefahren werden, beispielsweise mit einer Rate von 10A/Minute. Sobald ausreichend Strom durch den supraleitenden Magnet 2 fließt, kann ein Schalter geschlossen werden, sodass der Strom in einem geschlossenen Stromkreis des supraleitenden Magneten 2 praktisch widerstandsfrei fließt, ohne dass weitere Energie bzw. weiterer Strom von der Magnetstromversorgung 30 zugeführt werden muss. In diesem Zustand ist eine ständige Kühlung des Magneten 2 notwendig, um ein Aufwärmen des Magneten 2 auf über seine Sprungtemperatur zu verhindern.

Aufgrund der relativ geringen Menge an Helium in dem Heliumbehälter 9 würde bei einem Ausfall des ersten Kühlsystems 10 das Helium in dem Heliumbehälter 9 relativ schnell weitgehend vollständig verdampfen, wodurch der supraleitende Magnet 2 nicht mehr effektiv gekühlt würde. Um einem Quenchen des Magneten 2 zu verhindern, ist es in einem solchen Fall notwendig, den Magneten 2 ausreichend schnell herunterzufahren. Dies kann aber gerade bei Magneten mit hoher Feldstärke, beispielsweise drei Tesla oder mehr, problematisch sein, da einerseits ein Herunterfahren kaum so schnell möglich ist, wie mit dem verbleibenden flüssigen Helium die Kühlung des Magneten 2 aufrechterhalten werden kann. Zum anderen würde es einige Zeit dauern, bis der Magnet 2 wieder einsatzfähig ist, da dieser erst wieder heruntergekühlt und dann auf seine Betriebsfeldstärke gebracht werden müsste.

Bei einem Ausfall des ersten Kühlsystems 10 ist deshalb das zweite Kühlsystem 20 dazu ausgestaltet, die Kühlung für den supraleitenden Magneten 2 aufrechtzuerhalten und dazu mit in dem supraleitenden Magneten 2 gespeicherter Energie betrieben zu werden. Die Magnetstromversorgung 32 ist dazu bidirektional ausgestaltet, sodass beim Herunterfahren des supraleitenden Magneten 2 der Strom aus dem Magneten 2 als Gleichstrom über eine elektrische Leitung zu dem zweiten Kühlsystem 20 geleitet wird. Das zweite Kühlsystem 20 wird somit durch den Strom aus den Magneten 2 betrieben. Vorzugsweise wird dabei der supraleitende Magnet 2 gezielt so heruntergefahren und die Eingabespannung für das zweite Kühlsystem 20 wird so eingestellt, dass die erzeugte Spannung zur Versorgung des zweiten Kühlsystems 20 dem Bedarf zum Betreiben des zweiten Kühlsystems 20 entspricht. Das Magnetsystem, insbesondere die Steuervorrichtung 6, kann optional dazu ausgestaltet sein, bei einem Ausfall des ersten Kühlsystems 10 eine Fehleranzeige auszugeben und/oder einen Alarm zu initiieren.

Das zweite Kühlsystem 20 kann ähnlich ausgestaltet sein wie das erste Kühlsystem 10, wobei das zweite Kühlsystem 20 gegebenenfalls etwas weniger leistungsstark ausgestaltet sein kann, da es nicht in der Lage sein muss den Magneten 2 herunterzukühlen, sondern lediglich dazu geeignet sein muss, den Magneten 2 auf seiner Betriebstemperatur zu halten. Das zweite Kühlsystem 20 umfasst ebenfalls einen Kühler 22 und ein Kaltkopf 21, der von den Kühler 22 gekühlt wird. Optional kann das zweite Kühlsystem 20 weitere Komponenten, wie zum Beispiel einen Kompressor, umfassen. Es kann vorgesehen sein, dass Wärme von dem zweiten Kühlsystem 20 selbst ebenfalls durch den Wärmetauscher 13 abgeführt wird. Vorzugsweise optional kann es jedoch vorgesehen sein, dass das zweite Kühlsystem 20 einen eigenen Wärmetauscher 23 und/oder insbesondere eine eigene interne Wasserkühlung umfasst. Die Wasserkühlung kann dazu ausgestaltet sein, Wärme in dem zweiten Kühlsystem 20 umzuwälzen, um somit eine Überhitzung einzelner Komponenten des zweiten Kühlsystems 20 zu verhindern. Somit kann anfallende Wärme einzelner Komponenten des zweiten Kühlsystems 20 an eine Umgebung abgegeben werden, beispielsweise auf andere Komponenten bzw. Teile des Magnetsystems umgeleitet werden. Die Wasserkühlung kann insbesondere unabhängig von einem externen Wasseranschluss und von einer externen Stromversorgung sein. Beispielsweise kann die Wasserkühlung durch eine Wasserpumpe angetrieben werden, die ebenfalls durch die Energie des Magneten 2 betrieben wird. Vorteilhafterweise kann das zweite Kühlsystem 20 somit besonders unabhängig von einer externen Versorgung sein, und damit zum Beispiel auch dann noch funktionieren, wenn das erste Kühlsystem 10 deshalb ausfällt, weil eine Wasserkühlung des ersten Kühlsystems 10 ausgefallen ist.

Das Magnetsystem umfasst weiterhin eine passive Komponente zum Abbauen von Energie des supraleitenden Magneten 2 bei einem Ausfall des ersten Kühlsystems 10. Die passive Komponente ist vorzugsweise eine "Run-Down-Load" 33, beispielsweise umfassend mehrere in Reihe geschaltete Dioden, insbesondere Leistungsdioden. Die Dioden erzeugen einen Spannungsabfall und können dadurch Energie entnehmen und insbesondere in Wärme umwandeln. Beispielsweise können die Dioden auf einem Block mit ausreichend Wärmekapazität, um die anfallende Wärmeenergie aufzunehmen, angeordnet, beispielsweise einem Aluminium-Block. Vorzugsweise ist die passive Komponente beabstanded von dem Magneten 2 angeordnet, damit eine Erwärmung der passiven Komponenten nicht direkt zu einer Erwärmung des Magneten führt 2. Es kann ein Lüfter vorgesehen sein, zum Belüften der passiven Komponente. Der Lüfter kann insbesondere bei Magneten 2 mit hoher maximaler Feldstärke vorteilhaft sein. Die passive Komponente kann insbesondere dazu vorgesehen sein, falls nötig die übrige Energie des Magneten abzubauen, wenn diese nicht mehr ausreicht, um das zweite Kühlsystem 20 zu betreiben. Somit kann, selbst wenn eine Wiederherstellung des ersten Kühlsystems 10 nicht rechtzeitig erfolgt, die Energie des Magneten soweit heruntergefahren werden, dass ein Quenchen des Magneten verhindert werden kann. Während des Betriebs des zweiten Kühlsystems 20 mit der Energie des Magneten 2 wird die Spannung über die "Run-Down-Load" 33 bzw. die passive Komponente vorzugsweise so eingestellt, dass nur wenig Energie über die "Run-Down-Load" 33 bzw. die passive Komponente in Wärme umgewandelt wird.

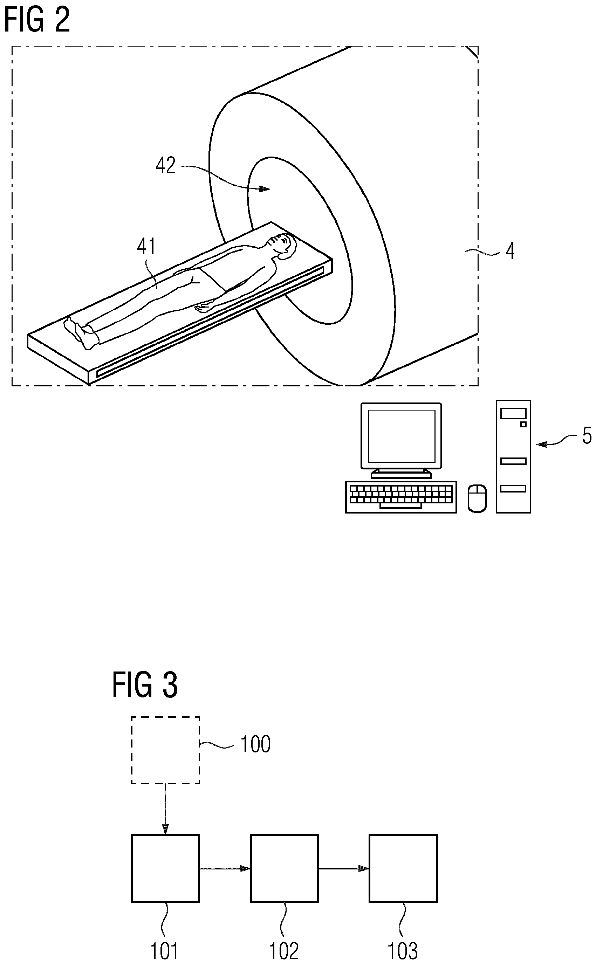

Figur 2 zeigt ein Magnetresonanztomographiesystem gemäß einer Ausführungsform der Erfindung mit einem erfindungsgemäßen Magnetsystem wie beispielsweise in Figur 1 gezeigt. Der Untersuchungstunnel 4 des Magnetresonanztomographiesystems umfasst die Magnetspule 3 des supraleitenden Magneten 2, wobei der supraleitende Magnet insbesondere der Hauptmagnet des Magnetresonanztomographiesystems ist. In dem Untersuchungstunnel 4 befindet sich ein Untersuchungsbereich 42, in den beispielsweise ein Patient 41 für eine Messung gefahren werden kann.

Das Magnetresonanztomographiesystem kann beispielsweise über eine Steuerkonsole 5 gesteuert werden. Im Falle eines Ausfalls des ersten Kühlsystems 10 kann beispielsweise eine Fehlermeldung auf der Steuerkonsole 5 angezeigt werden, um einen Nutzer zu warnen. Vorteilhafterweise können durch das erfindungsgemäße Magnetsystem mit der erfindungsgemäßen Kühlvorrichtung längere Ausfallzeiten des Magnetresonanztomographiesystems effektiv verhindert werden.

Figur 3 zeigt ein Flussdiagramm eines Verfahrens zum Aufrechterhalten einer Kühlung eines supraleitenden Magneten 2 bei Ausfall eines ersten Kühlsystems 10 mit einer Magnetspule 3 gemäß einer Ausführungsform der Erfindung. Vorzugsweise ist der supraleitende Magnet 2 ein trockener Magnet, d.h. der supraleitende Magnet 2 ist nicht in einem Heliumbad angeordnet, sondern steht lediglich in Wärmekontakt mit einer geringeren Menge an Helium. In einem ersten Schritt 101 wird der elektrische Strom des supraleitenden Magneten 2 kontrolliert heruntergefahren. Gleichzeitig wird in einem weiteren Schritt 102 eine Stromversorgung für ein zweites Kühlsystem 20 generiert, wozu der elektrische Strom, der dem supraleitenden Magneten beim Herunterfahren entnommen wird, verwendet wird. In einem weiteren Schritt 103 wird dabei eine Kühlung des supraleitenden Magneten 2 durch das zweite Kühlsystem 20 aufrechterhalten. Das erste Kühlsystem und das zweite Kühlsystem können vorzugsweise dazu ausgestaltet sein, einen Kaltkopf für einen Heliumbehälter mit Helium zum Kühlen des supraleitenden Magneten 2 zu betreiben. Optional kann ein weiterer Schritt 100 vorgesehen sein, in dem, während das erste Kühlsystem 10 noch funktioniert, das zweite Kühlsystem 20 in vorbestimmten Zeitintervallen auf seine Funktionsfähigkeit getestet wird. Die vorbestimmten Zeitintervalle sind insbesondere abhängig von einer Fehlereintrittswahrscheinlichkeit für einen Fehler des zweiten Kühlsystems 20 eingestellt sind. Mit anderen Worten wird das zweite Kühlsystem 20 so regelmäßig getestet, dass ein Fehler des zweiten Kühlsystems 20 mit einer vorgesehen Wahrscheinlichkeit, beispielsweise mindestens 95%, ausgeschlossen werden kann.

## Patentansprüche

1. Kühlvorrichtung zum Kühlen eines supraleitenden Magneten (2), insbesondere eines supraleitenden Magneten (2) für ein Magnetresonanztomographiesystem, wobei die Kühlvorrichtung umfasst:
- ein erstes Kühlsystem (10), wobei das erste Kühlsystem (10) dazu ausgestaltet ist, eine Kühlung für den supraleitenden Magneten (2) während eines Betriebs des supraleitenden Magneten (2) aufrechtzuerhalten,
- ein zweites Kühlsystem (20), wobei das zweite Kühlsystem (20) dazu ausgestaltet ist, bei einem Ausfall des ersten Kühlsystems (10) die Kühlung für den supraleitenden Magneten (2) aufrechtzuerhalten und dazu mit in dem supraleitenden Magneten (2) gespeicherter Energie betrieben zu werden.

2. Kühlvorrichtung gemäß Anspruch 1,
wobei das zweite Kühlsystem (20) dazu ausgestaltet ist, anfallende Wärme seiner Komponenten an eine Umgebung abzugeben.

3. Kühlvorrichtung gemäß Anspruch 1 oder 2,
wobei das zweite Kühlsystem (20) eine interne Wasserkühlung mit einer Wasserpumpe umfasst, wobei die Wasserkühlung dazu ausgestaltet ist, zumindest eine Komponente des zweiten Kühlsystems (20) zu kühlen,
wobei die zumindest eine Komponente insbesondere einen Kompressor des zweiten Kühlsystems (20) umfasst.

4. Kühlvorrichtung gemäß einem der vorhergehenden Ansprüche,
wobei die Kühlvorrichtung ein Steuergerät umfasst, das dazu ausgestaltet ist, wiederholt, insbesondere zyklisch in vorbestimmten Zeitintervallen, eine Funktionalität des zweiten Kühlsystems (20) zu überprüfen.

5. Kühlvorrichtung gemäß einem der vorhergehenden Ansprüche,
wobei das erste Kühlsystem (10) und das zweite Kühlsystem (20) jeweils einen Kaltkopf (11, 21) oder zusammen einen gemeinsamen Kaltkopf (11) umfassen zum Verflüssigen eines Kühlmittels, insbesondere zum Verflüssigen von Helium, mit dem der supraleitende Magnet (2) gekühlt wird.

6. Magnetsystem umfassend einen supraleitenden Magneten (2) mit einer Magnetspule (3) und eine Kühlvorrichtung gemäß einem der vorhergehenden Ansprüche,
wobei das Magnetsystem einen Kühlmittelbehälter, insbesondere Heliumbehälter, umfasst, der dazu ausgestaltet ist, verflüssigtes Kühlmittel zu beinhalten, und wobei ein Wärmeleitkontakt zwischen dem Inhalt des Kühlmittelbehälters und dem supraleitenden Magneten (2) besteht,
wobei das erste Kühlsystem (10) und das zweite Kühlsystem (20) jeweils dazu ausgestaltet sind, einem Verdampfen des verflüssigten Kühlmittels entgegenzuwirken und/oder verdampftes Kühlmittel zu verflüssigen.

7. Magnetsystem gemäß Anspruch 6,
wobei eine Energieversorgung des zweiten Kühlsystems (20) über zumindest eine elektrische Leitung mit einem elektrischen Stromkreis des supraleitenden Magneten (2) verbunden ist,
wobei das Magnetsystem dazu ausgestaltet ist, bei einem Ausfall des ersten Kühlsystems (10) den elektrischen Stromfluss durch den supraleitenden Magneten (2) kontrolliert herunterzufahren und einen dadurch generierten elektrischen Strom zum Betreiben des ersten Kühlsystems (10) einzusetzen.

8. Magnetsystem gemäß Anspruch 7,
wobei das Magnetsystem dazu ausgestaltet ist, den elektrischen Strom zum Betreiben des zweiten Kühlsystems (20) als Gleichstrom bereitzustellen.

9. Magnetsystem gemäß Anspruch 8,
wobei das Magnetsystem einen Gleichstromschaltung (30) umfasst, wobei die Gleichstromschaltung (30) eine bidirektionale Magnetstromversorgung (32) umfasst, die dazu ausgestaltet ist, in einem ersten Modus elektrischen Strom in die Magnetspule (3) einzuspeisen und in einem zweiten Modus elektrischen Strom der Magnetspule (3) zu entnehmen und in das zweite Kühlsystem (10) einzuspeisen,
wobei das Magnetsystem insbesondere einen Gleichrichter (31) zum Einspeisen von Gleichstrom in die Gleichstromschaltung (30) umfasst.

10. Magnetsystem gemäß einem der Ansprüche 7 bis 9,
wobei das Magnetsystem dazu konfiguriert ist, bei einem Ausfall des ersten Kühlsystems den supraleitenden Magneten (2) gezielt so herunterzufahren und ihm gezielt so elektrische Energie zu entnehmen, dass eine erzeugte Spannung zur Versorgung des zweiten Kühlsystems dem Bedarf zum Betreiben des zweiten Kühlsystems entspricht.

11. Magnetsystem gemäß einem der Ansprüche 6 bis 10,
wobei das Magnetsystem zumindest eine passive Komponente zum Abbauen von Energie des supraleitenden Magneten (2) bei einem Ausfall des ersten Kühlsystems umfasst, insbesondere von Energie, die nicht zum Betreiben des ersten Kühlsystems verwendet wird und/oder verwendbar ist.

12. Magnetresonanztomographiesystem umfassend ein Magnetsystem gemäß einem der Ansprüche 6 bis 11 und/oder eine Kühlvorrichtung gemäß einem der Ansprüche 1 bis 5, wobei der supraleitende Magnet (2) insbesondere der Hauptmagnet des Magnetresonanztomographiesystems ist.

13. Verfahren zum Aufrechterhalten einer Kühlung eines supraleitenden Magneten (2) mit einer Magnetspule (3), insbesondere eines supraleitenden Magneten (2) eines Magnetresonanztomographiesystems, bei Ausfall eines ersten Kühlsystems (10) für den supraleitenden Magneten umfassend die folgenden Schritte:
- kontrolliertes Herunterfahren des elektrischen Stroms des supraleitenden Magneten (2);
- Generieren einer Stromversorgung für ein zweites Kühlsystem (20) unter Verwendung von elektrischem Strom, der dem supraleitenden Magneten (2) beim Herunterfahren entnommen wird;
- Aufrechterhalten einer Kühlung des supraleitenden Magneten (2) durch das zweite Kühlsystem (20), insbesondere Betreiben eines Kaltkopfs (21) für einen Kühlmittelbehälter zum Kühlen des supraleitenden Magneten (2) mit dem zweiten Kühlsystem (20);
wobei insbesondere eine Kühlvorrichtung gemäß einem der Ansprüche 1 bis 5 und/oder ein Magnetsystem gemäß einem der Ansprüche 6 bis 11 verwendet wird.

14. Verfahren gemäß Anspruch 13, wobei, während das erste Kühlsystem (10) noch funktioniert, das zweite Kühlsystem (20) in vorbestimmten Zeitintervallen auf seine Funktionsfähigkeit getestet wird, wobei die vorbestimmten Zeitintervalle abhängig von einer Fehlereintrittswahrscheinlichkeit für einen Fehler des zweiten Kühlsystems (20) eingestellt sind.

15. Verwendung eines zweiten Kühlsystems (20) für ein Magnetsystem, insbesondere ein Magnetresonanztomographiesystem, mit einem supraleitenden Magneten (2), um bei einem Ausfall eines ersten Kühlsystems (10) des supraleitenden Magneten (2) eine Kühlung des supraleitenden Magneten (2) aufrechtzuerhalten, wobei das zweite Kühlsystem (20) bei dem Ausfall des ersten Kühlsystems (10) mit in dem supraleitenden Magneten (2) gespeicherter Energie betrieben wird.
